Europäisches Patentamt

(19) European Patent Office

Office européen des brevets

(11) Veröffentlichungsnummer: **0 221 916**
**B1**

(12) EUROPÄISCHE PATENTSCHRIFT

(45) Veröffentlichungstag der Patentschrift: **16.01.91**

(51) Int. Cl.⁵: **G 03 B 41/00,** G 03 F 9/00

(21) Anmeldenummer: **86902326.7**

(22) Anmeldetag: **10.04.86**

(86) Internationale Anmeldenummer:
**PCT/DE86/00157**

(87) Internationale Veröffentlichungsnummer:
**WO 86/07169 04.12.86 Gazette 86/26**

(54) VORRICHTUNG ZUR AUTOMATISCHEN BESTIMMUNG DER ABWEICHUNG ZWISCHEN DEN STRUKTUREN EINER VORLAGE UND DENEN EINES VERGLEICHSOBJEKTES.

(30) Priorität: **20.05.85 DE 3518043**

(43) Veröffentlichungstag der Anmeldung:
**20.05.87 Patentblatt 87/21**

(45) Bekanntmachung des Hinweises auf die Patenterteilung:
**16.01.91 Patentblatt 91/03**

(84) Benannte Vertragsstaaten:
**DE FR GB NL**

(56) Entgegenhaltungen:
**DE-A-3 305 014**
**US-A-3 865 483**
**US-A-4 165 149**

**Naumann Bauelemente der Optik 1983 ISBN 3-446-13379-8**

(73) Patentinhaber: **Wild Leitz GmbH**
**Ernst-Leitz-Strasse 30 Postfach 20 20**
**D-6330 Wetzlar 1 (DE)**

(72) Erfinder: **SCHUSTER, Erich**
**Friedrichstrasse 10**
**D-6338 Hüttenberg (DE)**
Erfinder: **KARTZOW, Manfred**
**Solmser Weg 36**
**D-6330 Wetzlar 21 (DE)**

Courier Press, Leamington Spa, England.

## Beschreibung

Die Erfindung betrifft eine Vorrichtung zur automatischen Bestimmung der Abweichung zwischen den Strukturen einer Vorlage und denen eines Vergleichsobjektes nach dem Oberbegriff des Patentanspruchs 1.

Die bezüglich ihrer gegenseitigen Ablage zu untersuchenden Strukturen können z.B. auf den in der Halbleiterfertigung gebräuchlichen Masken oder auch auf den durch Belichtungsprozesse hergestellten Wafern vorhanden sein. Es kann sich jedoch auch um andere Mikrostrukturen handeln, die auf Werkstücken zur Überprüfung ihrer Maßhaltigkeit angebracht werden.

Die Anforderungen der Halbleiterindustrie an die Genauigkeit der Meßgeräte für Forschung, Entwicklung und Produktionskontrolle wachsen in dem Maße, in dem die Masken und Wafer größer und ihre Strukturen kleiner werden. Es geht darum, den Fabrikationsprozeß zu überwachen und rechtzeitig zu korrigieren, um eine optimale Ausbeute zu erreichen.

Ein wirtschaftliches Verfahren zur Kontrolle der Maßhaltigkeit von Masken und Wafern aus der laufenden Fertigung ist ihr Vergleich mit einer Meistermaske. Die dazu entwickelten Maskenvergleichsgeräte (z.B. LEITZ-Liste Sach-Nr. 810-109) erlauben eine visuelle Beobachtung von Überdeckungsfehlern zwischen den Strukturen und eine visuell kontrollierte Messung der Überdeckungsfehler. Mit Hilfe von Mikrometerspindeln werden die zu vergleichenden Strukturen solange gegeneinander verschoben, bis ihre Kanten übereinander liegen. Dieses Verfahren ist zeitaufwendig und nicht frei von subjektiven Fehlereinflüssen durch die die Messung ausführende Person.

Aus der DE-OS 33 05 014 ist eine Anordnung bekannt, mit der Überdeckungsfehler durch eine fotometrische Messung automatisch ermittelt werden können. Wie bei den visuell kontrollierten Maskenvergleichsgeräten werden die zu vergleichenden Strukturen komplementärfarbig beleuchtet und überlagert abgebildet. Das überlagerte Bild der Strukturen wird in die Ebene eines Meßspaltes übertragen und relativ zu diesem bewegt. Die Energie des durch den Meßspalt hindurchtretenden Lichtes wird entsprechend den unterschiedlichen Wellenlängen in Lichtenergieanteile jeweils einer der Komplementärfarben zerlegt. Aus den Lichtenergieanteilen wird jeweils eine Signalkurve in Abhängigkeit von den Wegkoordinaten des Bildes relativ zum Meßspalt erzeugt. Aus diesen Signalkurven wird nach an sich bekannten Verfahren der Fotometrie zur Bestimmung von Strukturbreiten die Kantenlage der miteinander zu vergleichenden Strukturen bestimmt und daraus durch Differenzbildung der Überdeckungsfehler beider Strukturen zueinander berechnet. Diese automatisch arbeitende Meßanordnung erfordert die Erzeugung von zwei getrennten Bildkanälen, die durch komplementäre Farbkennung unterscheidbar sind.

Während wellenlängenabhängige Abbildungsunterschiede in den beiden Bildkanälen bei der visuellen Beobachtung des Mischbildes wegen der begrenzten spektralen Empfindlichkeit und des Auflösungsvermögens des Auges zum Teil vernachlässigt werden können, sind sie für eine fotometrische Messung, die auch eine Steigerung der Meßgenauigkeit bringen soll, extrem wichtig. Für eine meßtechnische Trennung der beiden Bildkanäle müssen die Abbildungsoptiken zunächst für die von ihnen zu übertragenden Farben optimal korrigiert werden. Das kann jedoch nur in dem Teil des Abbildungsstrahlenganges erreicht werden, in dem die Bildkanäle getrennt verlaufen. In dem Teil des Abbildungsstrahlenganges, in dem beide Bildkanäle überlagert übertragen werden, muß daher ein Kompromiß hinsichtlich der chromatischen Korrektur gefunden werden. Das gelingt umso besser, je geringer die Wellenlängendifferenz der beiden Komplementärfarben ist. Damit ergibt sich aber wiederum eine Schwierigkeit durch die für die Farbtrennung einzusetzenden Farbfilter. Diese haben nur eine begrenzte Kantensteilheit, so daß sich ein gewisser spektraler Überschneidungsbereich ergibt. Für die fotometrische Messung bedeutet dies ein Übersprechen des einen Bildkanals in den anderen.

Zusätzliche Schwierigkeiten entstehen durch die unterschiedliche spektrale Empfindlichkeit der Empfänger, die zu einem ungleichen Signal-/Rauschverhältnis in beiden Meßkanälen führt. Das erschwert die nachfolgende Signalverarbeitung.

Ein weiterer gravierender Nachteil der Farb-Kennung der Bildkanäle ergibt sich aus lichtenergetischen Überlegungen, da die Bandbreitenbegrenzung den ausgenutzten Spektralbereich der Lichtquelle notwendigerweise einschränkt. Je besser die durch die Kantenfilter erzeugte Farbaufspaltung ist, umso größer sind die Lichtverluste, die für die Messung nicht verwendet werden können. Bei schneller Abtastung der Strukturen reichen die für die einzelnen Spektralbereiche verbleibenden Lichtintensitäten zur Gewinnung eines guten Signal-/Rauschverhältnisses nicht mehr aus. Eine Erhöhung der Gesamtlichtstärke führt jedoch teilweise zu einer örtlichen Erwärmung der Objekte, die zu einer Zerstörung der Strukturen führen kann.

Besonders kritisch für eine Farb-Kennung sind die objektbedingten Kontrastverhältnisse. Unterschiedliche Einfärbung der Strukturen, Vergütungsschichten, Maskenmaterialien, Waferschichten usw. führen zu unterschiedlichen Farbkontrasten innerhalb der einzelnen Bildkanäle und auch im Vergleich beider Bildkanäle zueinander.

Da bei einer automatischen Messung immer auch eine visuelle Beobachtungsmöglichkeit des jeweiligen Meßbereichs möglich sein muß, ergeben sich in der Praxis für die Optimierung der einzelnen Einflußparameter zusätzliche Beschränkungen. Üblicherweise werden daher die Komplementärfarben rot und grün für die Farbkennung gewählt.

Es ist bekannt, daß zur Trennung zweier optischer Kanäle auch die Polarisationskennung des Lichts verwendet werden kann. Ein optisches Ausrichtungssystem, bei dem das Übersprechen zwischen zwei optischen Kanälen durch Polarisatoren in zwei unabhängigen Nachweiseinrichtungen unterbunden wird, ist aus US-A 3 865 483 bekannt.

Die Nachteile der Farbkennung werden durch die Polarisationskennung vermieden. Aus Naumann, H., Bauelemente der Optik, München, Wien, Hanser 1983, Seiten 552f, ist bekannt, daß das reflektierte Bündel an der Abtaststelle hinsichtlich des Polarisationszustandes geändert werden kann. Daher gibt es bei der Polarisationskennung objektbedingte Kontrastverhältnisse.

Der Polarisationszustand des Lichtes kann vom Auge jedoch nicht wahrgenommen werden, die erforderliche visuelle Beobachtungsmöglichkeit fehlt also.

Ein einfacher Ersatz der Farbkennung durch eine Polarisationskennung bei der gattungsgemäßen Vorrichtung nach DE-A 33 05 14 ist daher nicht möglich.

Der Erfindung lag daher die Aufgabe zugrunde, eine Vorrichtung zur automatischen Bestimmung der Strukturabweichungen so auszubilden, daß sie die mit einer Farbkennung verbundenen Nachteile vermeidet, insbesondere also eine optimale Ausnutzung der Energie der Lichtquelle erlaubt, in beiden Bildkanälen über den gesamten Abbildungsweg gleiche Abbildungs- und fotoelektrische Meßverhältnisse schafft, eine gute Trennung der Bildkanäle ohne Lichtverluste ermöglicht und deren Kontrastverhalten durch wellenlängenselektive Eigenschaften der Objekte nicht gestört wird. Daneben sollte eine visuell wahrnehmbare Komplementärfarbendarstellung der Strukturen geschaffen werden, die ohne Rückwirkung auf den fotometrischen Strahlengang ist und außerdem eine visuelle Überprüfung des fotometrischen Abtastbereiches ermöglicht werden. Weiterhin sollte die Vorrichtung eine Messung in zwei Koordinatenrichtungen erlauben, ohne die Notwendigkeit der Drehung der Objekte.

Diese Aufgabe wird bei einer Vorrichtung der eingangs genannten Art erfindungsgemäß durch die kennzeichnenden Merkmale des Anspruchs 1 gelöst. Vorteilhafte Weiterbildungen des Erfindungsgegenstandes ergeben sich aus den Merkmalen der Ansprüche 2 bis 7.

Bei der Erfindung wird anstelle der Farbkennung eine Polarisationskennung der Bildkanäle eingeführt. Damit wird es möglich, beide Bildkanäle mit Licht gleicher spektraler Zusammensetzung zu beleuchten, so daß eventuell vorhandene chromatische Abbildungsfehler sich auf beide Bildkanäle in gleicher Weise auswirken. Auf den fotoelekrischen Empfängern wird nach Aufspaltung der beiden Bildkanäle eine Strahlung gleicher spektraler Zuammensetzung angeboten, so daß Empfänger mit gleicher spektraler Empfindlichkeit gewählt werden können. Die direkte optische Kopplung zwischen dem bildablenkenden Schwingspiegel und einem Positionsmeßsystem erlaubt eine sehr genaue Bestimmung der relativen Lage zwischen Objektbild und Meßspalt.

Es ist ein wesentlicher Gedanke der Erfindung, daß dies eingeführt werden kann, da ein Weg für die visuelle Darstellung gefunden wurde.

In den Strahlenausgängen für die visuelle Darstellung können Phasenplatten eingefügt werden, die eine konstante Phasenschiebung zwischen den beiden Polarisationsrichtungen der Bildkanäle erzeugen. Im Zusammenwirken mit nachgeschalteten Polarisationsfiltern entstehen dann aufgrund von an sich bekannten Interferenzeffekten den Bildkanälen zugeordnete Komplementärfarben. Die Farbdarstellung ist ausschließlich von der eingeführten Phasenverschiebung abhängig und ist insbesondere völlig ohne Rückwirkung auf den Meßstrahlengang.

Eine optimale Ausnutzung der in den einzelnen Bildkanälen vorhandenen Lichtintensität wird erreicht, wenn die Polarisationskennung am Ort der Zusammenführung der Bildkanäle eingeführt wird. Nach der Zusammenführung der beiden Bildkanäle können durch Einfügen mehrerer Neutral-Teilerflächen mehrere Strahlenausgänge geschaffen werden, die für unterschiedliche Darstellungszwecke verwendet werden könne. In den Meßstrahlengang kann insbesondere ein an sich bekanntens Prisma zur Bilddrehung eingefügt werden, mit dessen Hilfe auf einfache Weise eine Messung nach zwei Koordinatenrichtungen ermöglicht wird. Da die Polarisationsvektoren der beiden Bildkanäle bei einer Drehung des Prismas nicht mehr senkrecht bzw. parallel zu den Reflexionsflächen liegen, entsteht eine elliptische Polarisation, die jedoch durch eine am Ausgang des Drehprismas angebrachte Phasenplatte mit geeigneter Phasenverschiebung wieder kompensiert werden kann.

Eine vorteilhafte Ergänzung der Vorrichtung ergibt sich durch die rückwärtige Beleuchtung des Meßspaltes. Bei Einspiegelung des Meßspaltes über ein Tripelprisma in den Strahlengang zur visuellen Beobachtung bewegt sich der Spalt relativ zur feststehenden Struktur. Damit kann der abgetastete Meßbereich kontrolliert und eventuell durch manuellen Eingriff korrigiert werden.

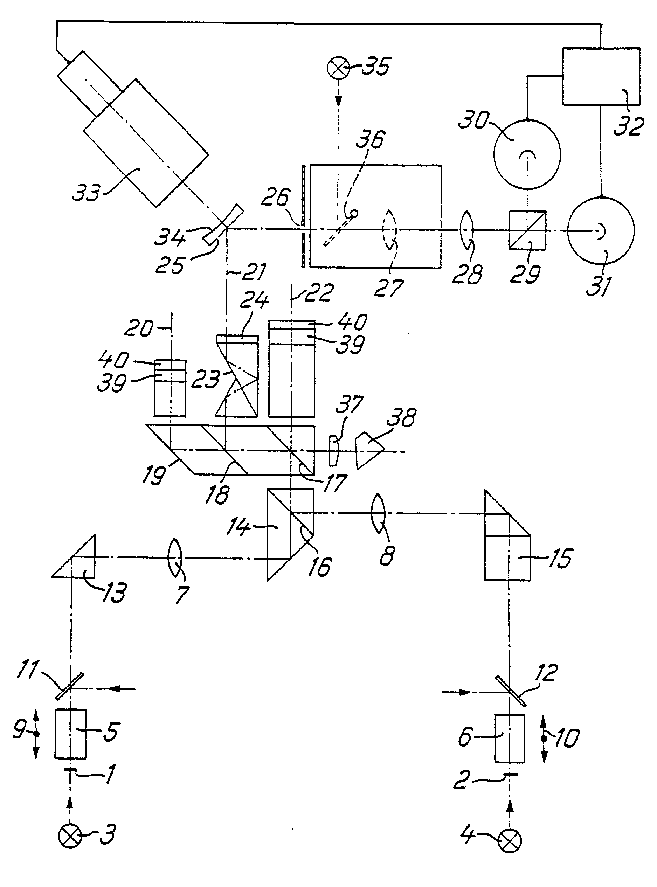

Ein Ausführungsbeispiel der Erfindung wird nachfolgend anhand der schematischen Darstellung in der Zeichnung beschrieben.

Eine Maske 1 mit bestimmten Strukturelementen oder Meßmarken und eine Maskenkopie 2 sind auf einem nicht weiter dargestellten, in x- und y-Richtung verschiebbaren Objekttisch angeordnet. Die Maske und ihre Kopie werden durch Lichtquellen 3 und 4 beleuchtet. Die Lichtquellen emittieren weißes Licht. Es ist selbstverständlich auch möglich, anstelle von zwei Lichtquellen eine einzige zu verwenden und ihre Strahlung durch Umlenkspiegel auf die beiden Objekte zu richten. Die Abbildung der Objekte erfolgt durch Objektive 5 und 6, sowie durch eventuell notwendige Tubusoptiken 7 und 8. Die Objektive 5 und 6 sind mit einer durch die Pfeile 9 und 10 angedeuteten Autofokuseinrichtung verbunden. Anstelle der dargestellten Durchlichtbeleuchtung kann mit Hilfe der Teilerspiegel 11 und 12 auch eine Auflichtbeleuchtung erfolgen.

Über Umlenkprismen 13, 14, 15 werden die beiden Bildkanäle an dem polarisierenden Teilerspiegel 16 zusammengeführt. Sowohl die Glaswege als auch die Luftwege in den beiden Bildkanälen bis zur Vereinigung an dem Teilerspiegel 16 sind so gewählt, daß sie übereinstimmen. Die durch den polarisierenden Teilerspiegel 16 hindurchtretenden Strahlen und die an ihm reflektierten Strahlen sind zueinander senkrecht linear polarisiert. Damit haben beide Bildkanäle eine Kennung erhalten.

In den überlagerten Strahlengang sind nachfolgend zwei Neutral-Teilerspiegel 17, 18 und eine total reflektierende Spiegelfläche 19 eingefügt, durch die drei Strahlenausgänge 20, 21, 22 geschaffen werden. Der Ausgang 21 ist der Meßstrahlengang. Der Ausgang 20 kann beispielsweise für eine Fernsehdarstellung verwendet werden und der Ausgang 22 für eine visuelle Beobachtung durch ein Okular oder in einer Mattscheibenprojektion.

In den Meßstrahlengang 21 ist ein Abbé-König-Prisma 23 zur Bilddrehung eingefügt. An seiner Strahlenausgangsseite ist mit dem Prisma 23 eine Phasenplatte 24 fest verbunden. Es kann sich dabei z.B. um ein dünnes Quarzplättchen handeln, dessen optische Achsen in der Normalstellung des Prismas 23 parallel zu den Polarisationsvektoren der beiden Bildkanäle ausgerichtet sind. Da zur Erzeugung einer Bilddrehung von 90° eine Drehung des Prismas 23 um 45° notwendig ist, stehen die Reflexionsflächen des Prismas in dieser Stellung nicht mehr parallel bzw. senkrecht zu den Polarisationsvektoren der beiden Bildkanäle. Beide Polarisationsvektoren erhalten daher eine Phasenverschiebung, die, wie sich in der Praxis gezeigt hat, etwa $\lambda/4$ entspricht. Aus der Linearpolarisation ist daher in etwa eine Zirkularpolarisation geworden. Die mitgedrehte Phasenplatte 24 ist nun so ausgewählt, daß sie die Phasenverschiebung in den beiden Bildkanälen wieder rückgängig macht. In dem weiterführenden Strahlengang haben beide Bildkanäle dann wieder ihre ursprüngliche Polarisationsrichtung.

Der Meßstrahlengang 21 wird dann über einen Schwingspiegel 25 auf einen Meßspalt 26 geleitet. Die Abbildungsoptik der beiden Bildkanäle ist so abgestimmt, daß in der Spaltebene 26 ein überlagertes Bild der Maske 1 und der Maskenkopie 2 entsteht. Mit Hilfe der Linsen 27, 28 wird der Meßspalt 26 dann über einen Analysator 29 (polarisierender Teilerspiegel) auf fotoelektrische Empfänger 30, 31 abgebildet. Der Analysator 29 trennt den Meßstrahlengang entsprechend den den beiden Bildkanälen zugeordneten Polarisationsrichtungen.

Zur Durchführung der Messung schwingt der Spiegel 25 um eine senkrecht zur Zeichenebene stehende Achse, so daß das überlagerte Bild der beiden Strukturen periodisch über den Meßspalt 26 hinwegbewegt wird. Die dabei von den fotoelektrischen Empfängern 30,31 erzeugten elektrischen Signalkurven werden einer Verarbeitungsschaltung 32 zugeführt. Mit dem Schwingspiegel 25 gekoppelt ist ein an sich bekanntes fotoelektrisches Wegmeß- bzw. Winkelmeßgerät 33. Die Kopplung erfolgt dadurch, daß die Rückseite 34 des Schwingspiegels 25 in Reflexion mit dem optischen Strahlengang des Meßsystems 33 verbunden ist. Die der jeweiligen Stellung des Schwingspiegels 25 entsprechenden Signale des Meßgerätes 33 werden ebenfalls der Verarbeitungsschaltung 32 zugeführt. Ein geeignetes Wegmeßsystem 33 mit Antriebseinheit für den Schwingspiegel 25 ist z.B. in der Patentanmeldung P 35 17 070.0 (unsere Aktenzeichen A 2224/B 3072, eingegangen beim Patentamt am 11.05.85) beschrieben.

Die Verarbeitungsschaltung 32 ermittelt aus den den Bildkanälen zugeordneten Signalkurven je einen Wert für die Lage der Kante der angemessenen Struktur. Durch Differenzbildung ergibt sich die Größe der Abweichung zwischen den überlagerten Strukturen in einer Koordinatenrichtung.

Zur Überprüfung des abgetasteten Objektbereiches ist eine rückwärtige Beleuchtung des Meßspaltes 26 mit Hilfe einer Pilot-Beleuchtung 35 und eines in den Meßstrahlengang einschwenkbaren Spiegels 36 möglich. Die Spaltbeleuchtung wird über den Schwingspiegel 25, das Drehprisma 23, den Teilerspiegel 18, eine Hilfsoptik 37 und ein Tripelprisma 38 nach Reflexion an dem Teilerspiegel 17 z.B. in den visuellen Beobachtungsstrahlengang 22 eingespiegelt. Während im Meßstrahlengang das Objektbild über den Meßspalt wandert, ergibt sich bei der Okularbetrachtung eine Wanderung des Meßspaltes über das ruhende Objektbild. Da die Spaltabbildung bei Drehung des Prismas 23 ebenfalls gedreht wird, kann die Abtastung des Objektbereiches in beiden Koordinatenrichtungen überprüft werden.

Zur Erzeugung einer Komplementärfarbendarstellung ist in die Strahlengänge 20 und 22 je eine Kombination aus Phasenplatte 39 und Polarisationsfilter 40 eingefügt. Die Wirkungsweise, mit der diese Bauelementekombination aus einem Strahlengang mit zueinander senkrecht linear polarisierten Komponenten eine Farbdarstellung erzeugt, ist an sich bekannt. Die Polarisationsvektoren des Filters 40 müssen parallel zu den Polarisationsrichtungen des polarisierenden Teilerspiegels 16 ausgerichtet werden. Führt man dann z.B. mit Hilfe der Phasenplatte 39 für eine mittlere Wellenlänge $\lambda = 550$ nm aus dem Spektrum des Beleuchtungslichtes eine Phasenverschiebung von $2\lambda$ ein, so ergibt sich aufgrund von Interferenzen für den einen Bildkanal eine rote und für den anderen Bildkanal eine grüne Darstellung. Durch die Wahl anderer Phasenverschiebungen können auch andere Komplementärfarbenkombinationen gewählt werden.

**Patentansprüche**

1. Vorrichtung zur automatischen Bestimmung der Abweichung zwischen den Strukturen einer Vorlage (1) und denen eines Vergleichsobjektes (2) mit

a) mit mindestens einer weißes Licht emittierenden Lichtquelle (3, 4) zur Strukturabbildung,

b) zwei Abbildungsstrahlengängen mit optischen Mitteln (5, 6, 7, 8, 28, 29) und orthogonal zueinander wirkenden linear polarisierenden Elementen (18) zur Erzeugung von mit einer Polarisationskennung versehenen Abbildungen der beiden zu vergleichenden Strukturen (1, 2),

c) mindestens einem Neutral-Teilerspiegel (17, 18) zur Auskopplung eines visuellen und/oder Fernseh-Beobachtungsstrahlenganges (20, 22),

d) einer in den visuellen und/oder Fernseh-Strahlengang (20, 22) eingefügten Phasenplatte (39) mit zugeordneten Polarisationsfiltern (40) zur Erzeugung einer der Polarisationskennung entsprechenden Farbkennung der Abbildungsstrahlen.

e) Mitteln zur Zusammenführung (16) der Abbildungsstrahlengänge zu einem gemeinsamen Abbildungsstrahlengang,

f) Mitteln zur Abbildung (5, 6, 7, 8) der zu vergleichenden Strukturen (1, 2) auf einen Meßspalt (26),

g) einen zwischen Bild und Meßspalt (26) angeordneten Schwingspiegel (25), der mit einem fotoelektrischen Weg- oder Winkelmeßsystem (33) gekoppelt ist, zur Erzeugung einer Relativbewegung zwischen dem überlagerten Bild der beiden Strukturen und dem Meßspalt (26),

h) orthogonal zueinander wirkenden polarisierenden Elementen (29) zur Zerlegung der durch den Meßspalt (26) hindurchtretenden Strahlung entsprechend der Polarisationskennung und Mitteln zur Abbildung (28) der Strahlungsanteile auf fotoelektrische Empfänger (30, 31),

i) Mitteln zur Erzeugung von Signalkurven (32) in Abhängigkeit von der Relativlage zwischen Bild und Meßspalt (26) und

j) Mitteln zur Auswertung der Signalkurven (32) in Bezug auf eine gegenseitige Verschiebung.

2. Vorrichtung nach Anspruch 1, dadurch gekennzeichnet, daß zur Erzeugung der Polarisationskennung am Ort der Zusammenführung der beiden Abbildungsstrahlengänge (16) und am Ort der Zerlegung (29) der Abbildungsstrahlengänge je ein linear polarisierender Teilerspiegel (16, 29) vorgesehen sind.

3. Vorrichtung nach Anspruch 1, dadurch gekennzeichnet, daß der ebene Schwingspiegel (25) auf seiner Rückseite eine Spiegelfläche (34) trägt, die mit einem dem Weg- oder Winkelmeßsystem (33) zugeordneten Abbildungssystem zusammenwirkt.

4. Vorrichtung nach Anspruch 1, dadurch gekennzeichnet, daß dem Schwingspiegel (25) in dem gemeinsamen Abbildungsstrahlengang (21) ein Prisma (23) zur Bilddrehung vorgeschaltet ist.

5. Vorrichtung nach Anspruch 4, dadurch gekennzeichnet, daß als Prisma zur Bilddrehung ein Abbé-König-Prisma (23) vorgesehen ist.

6. Vorrichtung nach Anspruch 4 oder 5, dadurch gekennzeichnet, daß dem Prisma (23) eine Phasenplatte (24) zur Kompensation der durch Reflexion an den Prismenflächen entstehenden elliptischen Polarisation nachgeschaltet ist.

7. Vorrichtung nach Anspruch 1, dadurch gekennzeichnet, daß dem Meßspalt (26) ein schwenkbarer Spiegel (36) nachgeschaltet ist, über den der Meßspalt (26) entgegen der Richtung der Abbildungsstrahlen (21) für die zu vergleichenden Strukturen (1, 2) beleuchtet (35) wird, wobei diese Beleuchtungsstrahlen über den Schwingspiegel (25), die dem strahlzusammenführenden Teilerspiegel (16) nachgeschalteten Neutral-Teilerspiegel (18, 17) und ein Tripelprisma (38) dem visuellen und/oder Fernseh-Beobachtungsstrahlengang (20, 22) zugeführt werden.

**Revendications**

1. Dispositif pour déterminer automatiquement l'écart entre les structures d'un modèle (1) et celles d'un objet comparé (2) avec

a) au moins une source de lumière (3, 4) émettant de la lumière blanche pour la représentation de la structure,

b) deux trajets de rayons de représentation avec des moyens optiques (5, 6, 7, 8, 28, 29) et éléments polarisants linéaires agissant orthogonalement l'un à l'autre (18) pour la production de représentations pourvues d'une caractéristique de polarisation des deux structures à comparer (1, 2),

c) au moins un miroir diviseur neutre (17, 18) pour le découplage d'un trajet de rayons (20, 22) d'observation visuelle et/ou par télévision,

d) un filtre déphasant (39) inséré dans le trajet des rayons visuels et/ou de télévision (20, 22) avec filtres affectés de polarisation (40) pour la production d'une caractéristique de couleur correspondant à la caractéristique de polarisation des rayons de représentation,

e) des moyens pour la réunion (16) des trajets de rayons de représentation en un trajet commun de rayons de représentation,

f) des moyens pour la représentation (5, 6, 7, 8) des structures à comparer (1, 2) sur une fente de mesure (26),

g) un miroir pivotant (25) agencé entre image et fente de mesure (26), qui est couplé à un système photoélectrique de mesure du déplacement ou de l'angle (33), pour la production d'un mouvement relatif entre l'image superposée des deux structures et la fente de mesure (26),

h) des éléments polarisants agissant orthogonalement l'un à l'autre (29) pour la dispersion du rayonnement ayant traversé la fente de mesure (26) selon la caractéristique de polarisation et des moyens pour la représentation (28) des composants du rayonnement sur des récepteurs photoélectriques (30, 31),

i) des moyens pour la production de courbes de signaux (32) dépendant de la position relative entre l'image et la fente de mesure (26), et

j) des moyens pour l'évaluation des courbes de signaux (32) relativement à un déplacement mutuel.

2. Dispositif selon la revendication 1, caractérisé en ce q'ue, pour la production de la caractéristique de polarisation à l'emplacement de la réunion des deux trajets de rayons de représentation (16) et à l'emplacement de la dispersion (29) des trajets de rayons de représentation sont prévus à chaque fois un miroir partiel de polarisation linéaire (16, 29).

3. Dispositif selon la revendication 1, caractérisé en ce que le miroir pivotant plan (25) porte, à son côté arrière, une surface de miroir (34) qui coopère avec un système de représentation affecté au système de mesure du déplacement ou de l'angle (33).

4. Dispositif selon la revendication 1, caractérisé en ce que le miroir pivotant (25) est précédé, dans le trajet commun de rayons de représentation (21), d'un prisme (23) pour la rotation de l'image.

5. Dispositif selon la revendication 4, caractérisé en ce qu'en tant que prisme pour la rotation de l'image est prévu un prisme central de Abbé (23).

6. Dispositif selon la revendication 4 ou 5, caractérisé en ce que le prisme (23) est suivi d'un filtre déphasant (24) pour la compensation de la polarisation elliptique résultant de la réflexion sur les surfaces du prisme.

7. Dispositif selon la revendication 1, caractérisé en ce que la fente de mesure (26) est suivie d'un miroir pivotant (36) par lequel la fente de mesure (26) est éclairée (35) de façon opposée à la direction des rayons de représentation (21) pour les structures à comparer (1, 2), et ces rayons d'éclairement sont conduits par le miroir pivotant (25), le miroir partiel neutre suivant le miroir diviseur (16) réunissant les rayons et un prisme triple (38), au trajet de rayons d'observation visuelle et/ou par télévision (20, 22).

**Claims**

1. Device for the automatic determination of the deviation between the structures of a master original (1) and those of a comparison object (2) with

a) at least one light source (3, 4) emitting white light for imaging of structures,

b) two imaging ray paths with optical means (5, 6, 7, 8, 28, 29) and linearly polarising elements (18), which each act orthogonally to the other, for the production of images, which are provided with an identification of the polarisation, of both the structures (1, 2) to be compared,

c) at least one neutral divider mirror (17, 18) for the coupling-out of a visual and/or television observation ray path (20, 22),

d) a phase plate (39), which is inserted into the visual and/or television ray path (20, 22), with associated polarisation filters (40) for the production of a colour identification of the imaging rays, which corresponds with the identification of the polarisation,

e) means for the uniting (16) of the imaging ray paths into a common ray path,

f) means for the imaging (5, 6, 7, 8) of the structures (1, 2) to be compared onto a measuring gap (26),

g) an oscillatory mirror (25), which is arranged between the image and the measuring gap (26) and coupled with a photo-electric travel-measuring or angle-measuring system (33), for the production of a relative movement between the superposed image of both the structures and the measuring gap (26),

h) polarising elements (29), which each act orthogonally to the other, for the resolution of the radiation, which passes through the measuring gap (26), in accordance with the identification of the polarisation and means for the imaging (28) of the radiation components onto photo-electric receivers (30, 31),

i) means for the production of signal curves (32) in dependence on the relative position between the image and the measuring gap (26) and

j) means for the evaluation of the signal curves (32) with regard to a relative displacement.

2. Device according to claim 1, characterised thereby, that a respective linearly polarising divider mirror (16, 29) is provided at the place of the union of both the imaging ray paths (16) and at the place of the resolution (29) of the imaging ray paths for the production of the identification of the polarisation.

3. Device according to claim 1, characterised thereby, that the planar oscillatory mirror (25) on its rear side carries a mirror surface (34), which cooperates with an imaging system associated with the travel-measuring or angle-measuring system (33).

4. Device according to claim 1, characterised thereby, that a prism (23) for image rotation is connected in the common imaging ray path in front of the oscillatory mirror (25).

5. Device according to claim 4, characterised thereby, that an Abbe-König prism (23) is provided as prism for image rotation.

6. Device according to claim 4 or 5, characterised thereby, that a phase plate (24) for the compensation of the elliptical polarisation arising through reflection at the prism surfaces is connected behind the prism (23).

7. Device according to claim 1, characterised thereby, that a pivotable mirror (36), by way of which the measuring gap (26) is illuminated (35) against the direction of the imaging rays (21) for the structures (1, 2) to be compared, is connected behind the measuring gap (26), wherein these illumination rays are conducted by way of the oscillatory mirror (25), the neutral divider mirrors (18, 17) connected behind the ray-uniting divider mirror (16) and a triple prism (38) to the visual and/or television observations ray path (20, 22).